# NEUE EUROPÄISCHE PATENTSCHRIFT

(11) **EP 0 355 255 B2**
(45) Veröffentlichungstag und Bekanntmachung des Hinweises auf die Entscheidung über den Einspruch: **06.10.1999**
(45) Hinweis auf die Patenterteilung: 15.09.1993
(21) Anmeldenummer: 89106002.2
(22) Anmeldetag: 06.04.1989
(51) Int. Cl.: H02K 11/00, F04D 15/00, G01R 31/34

(54) **Diagnosestecker**
Diagnostic plug
Fiche de diagnostic

(30) Priorität: 19.08.1988 DE 3828207
(43) Veröffentlichungstag der Anmeldung: 28.02.1990
(73) Patentinhaber: WILO GmbH, D-44263 Dortmund (DE)
(72) Erfinder: Greitzke, Stephan, Dr., D-4600 Dortmund 30 (DE); Hübner, Jürgen, D-4600 Dortmund 41 (DE); Grammling, Franz, Dipl.-Ing., D-7000 Stuttgart 80 (DE); Hahn, Martin, D-4600 Dortmund 1 (DE); Kech, Hansjürgen, Dipl.-Ing., D-5804 Herdecke (DE)
(74) Vertreter: COHAUSZ HANNIG DAWIDOWICZ & PARTNER

(56) Entgegenhaltungen:
- DE-A- 3 342 967
- DE-U- 8 703 832
- FR-A- 2 529 965
- WORLD PUMPS. no. 5, Mai 1986, MORDEN GB Seite 120 "Computerised pump controller"
- PATENT ABSTRACTS OF JAPAN vol. 11, no. 61 (E-483)(2508) 25 Februar 1987, & JP-A-61 221549 (TOSHIBA) 1 Oktober 1986,
- PATENT ABSTRACTS OF JAPAN vol. 8, no. 59 (E-232)(1496) 17 März 1984, & JP-A-58 207838 (FUJI) 3 Dezember 1983,
- Prospekt-Doppelblatt Grundfos "Sternstunde der Pumpentechnik UP Inteligenz..."

## Beschreibung

Die Erfindung betrifft ein elektrisch angetriebenes Pumpenaggregat, mit in einem Gehäuse angeordneten Elektromotor und einer Pumpe sowie einem mit einer Meßvorrichtung für die elektrischen bzw. hydraulischen Betriebsgrößen von Motor bzw. Pumpe verbundenen Anschlußbaustein, auf dem von außen lösbar ein weiterer Baustein befestigbar ist.

Ein solches Pumpenaggregat ist aus der nicht vorveröffentlichten Patentanmeldung 38 07 832 der Anmelderin bereits bekannt. Bei diesem bekannten Aggregat ist auf den Anschlußbausteinein Umschaltstecker steckbar, je nach dessen Stellung in Bezug zu den Stiften des Anschlußbausteins unterschiedliche Betriebszustände, z.B. Drehzahlbereiche, für das Aggregat fest vorgegeben werden können. Dies hat den Vorteil, daß auf diese Weise das Pumpenaggregat an die spezielle Anwendung auf einfache Weise angepaßt werden kann, ohne daß die Gefahr besteht, daß durch unbefugtes Manipulieren die Pumpe beschädigt wird. Darüber hinaus kann bei dem bekannten Aggregat auf den Anschlußbaustein ein Modul zum Motorschutz aufgebracht werden, welches auf Überstrom je nach Wahl der Drehzahlstufe des Motors anspricht.

Andererseits ist es aus der DE-PS 32 25 141 bei elektrisch angetriebenen Pumpenaggregaten bekannt, in Kenntnis der elektrischen Betriebsgrößen des Motors, wie Stromaufnahme, Drehzahl und Leistungsaufnahme die hydraulischen Größen der Pumpe je nach Belastung durch das Leitungsrohrnetz mittels des Pumpenkennlinienfeldes zu berechnen. Die hydraulischen Betriebsgrößen der Pumpe sind Differenzdruck, Volumenstrom bzw. hydraulischer Widerstand. Zur Erfassung dieser elektrischen bzw. hydraulischen Betriebsgrößen zum Zwecke des Anpassens des Pumpenaggregates während seiner Installation an das bestehende bzw. neuzuerstellende Leitungsrohrnetz eines Heizungssystems erfolgt - wie bislang bekannt - durch Anschluß externer Meßgeräte an das Aggregat. Hierzu ist das Gehäuse üblicherweise zu öffnen. Nach Zusammenbau und Einfahren des Aggregates sind die Betriebsgrößen von Motor bzw. Pumpe nur noch erschwert zugänglich, so daß eine Fehlerdiagnose an im Betrieb befindlichen Pumpenaggregaten mit großem Meßaufwand verbunden ist.

Der Erfindung liegt daher die Aufgabe zugrunde, ein Pumpenaggregat der eingangs genannten Art derart weiterzuentwickeln, daß die Erfassung der Betriebsgrößen von Motor und Pumpe anzeigbar und/oder speicherbar sind.

Diese Aufgabe wird erfindungsgemäß dadurch gelöst, daß der weitere Baustein eine Registriervorrichtung umfaßt, mittels der die Betriebsgrößen von Motor und Pumpe anzeigbar und/ oder speicherbar sind.

Durch den lösbar aufsetzbaren weiteren Baustein sind nunmehr die von der Meßvorrichtung innerhalb des Gehäuses ermittelten Betriebsgrößen auch während des Pumpenbetriebs on-line zugänglich, ohne daß der Pumpenbetrieb zum Anschluß von externen Meßgeräten unterbrochen werden müßte. Dabei zeichnet sich die Erfindung durch einen äußerst einfachen Aufbau aus, indem der "Diagnosestecker" lediglich auf den vorhandenen Anschlußbaustein aufgesetzt werden muß, da die Schnittstelle pumpenintern bereits die Werte der elektrischen und/oder hydraulischen Betriebsgrößen erhält. Hierdurch ergibt sich auch die Möglichkeit, daß derselbe Diagnosestecker nacheinander mit verschiedenen Pumpenaggregaten in Verbindung gebracht werden kann, so daß hierdurch einerseits ein Erfassen der elektrischen bzw. hydraulischen Betriebsgrößen möglich ist, andererseits aber auch ein Vergleich von an einer ersten Pumpe gemessenen Betriebsgrößen mit denen einer zweiten Pumpe ermöglicht wird. Der Einsatz des Diagnosesteckers eignet sich dabei sowohl für Pumpen mit fest vorgegebenen Drehzahlstufen als auch für solche, bei denen die Drehzahl frei wählbar ist.

Vorzugsweise ist mit der Registriervorrichtung eine Anzeigevorrichtung für die elektrischen Betriebsgrößen des Motors verbunden, die insbesondere auf unterschiedliche elektrische Betriebsgrößen wie Stromaufnahme, Drehzahl oder Leistungsaufnahme umschaltbar ist. Hierdurch ergibt sich die einfache Möglichkeit der kontinuierlichen Anzeige der für das Betriebsverhalten des Pumpenaggregates wesentlichen Größen. Dies gilt ebenso für die hydraulischen Betriebsgrößen, deren Änderung direkt von dem jeweiligen Zustand des angeschlossenen Leitungsrohrnetzes abhängen. Hierdurch kann eine allmähliche Veränderung des Leitungsrohrnetzes, z.B. durch Verschlammung, durch Messung der Änderung der hydraulischen Größen erkannt werden, so daß eine evtl. Überlastung des Pumpenaggregates vermieden wird.

Insbesondere ist es von Vorteil, wenn die erfaßten Betriebsgrößen nicht nur angezeigt, sondern auch abgespeichert werden, indem die Registriervorrichtung einen elektronischen Speicher enthält. Hierdurch lassen sich zu bestimmten Zeiten aufgenommene Meßwerte oder Meßwert folgen der Betriebsgrößen abspeichern und zu einem späteren Zeitpunkt mit den jeweils aktuellen Werten vergleichen. Auch hierdurch kann eine unerwünschte allmähliche Veränderung des angeschlossenen Leitungsrohrnetzes, beispielsweise bedingt durch Undichtigkeiten oder Verschlammung, auf einfache Weise erkannt werden.

Ein weiterer besonderer Vorteil ergibt sich dann, wenn der elektronische Speicher ein batteriegepufferter RAM ist. Hierdurch ist eine Ferndiagnose für Fehler in Pumpenaggregaten möglich, indem der Diagnosestecker auf die zu messende Pumpe aufgesetzt wird, die jeweiligen Betriebsgrößen als Meßwert folge erfaßt werden und anschließend der Diagnosestecker mit den im RAM abgelegten Meßwerten zu einer Vergleichspumpe verschickt wird. Die abgespeicherten Meßwerte gehen dabei aufgrund der Batteriepufferung nicht verloren.

Der Aufwand für die Installation und die Wartung von Pumpenaggregaten läßt sich durch die Erfindung wesentlich vereinfachen, da die Steckverbindung beispielsweise als serielle Schnittstelle ausgeführt sein kann, über die die Betriebsgrößen, die von der Meßvorrichtung erfaßt sind, in einen Rechner eingelesen werden können. Da die Daten für die Meßwerte nur in einer Richtung, nämlich von der Meßvorrichtung in die Registriervorrichtung fließen, reichen für die Datenübertragung zwei Leitungen aus, so daß der Stecker als zweipoliger Klinkenstecker ausgeführt sein kann.

Es ist ebenfalls vorteilhaft, wenn der Anschlußbaustein eine Leuchtdiode enthält und wenn der weitere Baustein eine die Strahlung der Leuchtdiode aufnehmende Empfangseinrichtung, insbesondere einen Fototransistor, aufweist. Hierdurch ergibt sich eine sehr einfache Ausführung der Schnittstelle zur Übertragung der Daten ohne Berührung von Anschlußbausteinen und Empfangseinrichtung. Eine ähnlich vorteilhafte Ausführungsform ist dann gegeben, wenn der Anschlußbaustein einen Sender und der weitere Baustein einen Empfänger enthält, so daß auch hierbei die Daten, die den Betriebsgrößen des Motors entsprechen, drahtlos übertragen werden können.

Die erfindungsgemäße Vorrichtung bietet auf denkbar einfache Weise die Möglichkeit, ohnehin bereits innerhalb der Pumpe vorhandene Daten für die hydraulischen bzw. elektrischen Betriebsgrößen extern anzuzeigen und weiter zu verarbeiten. Somit kann das erfindungsgemäße Pumpenaggregat eingesetzt werden zur Fehlersuche oder Fehlerdiagnose in bestehenden Leitungsrohrnetzen oder zur Analyse und Prüfung von neu zu erstellenden Leitungsrohrnetzen. Dazu können beispielsweise die aktuell an einer bestimmten Pumpe gemessenen Datenfolgen mit zu einem früheren Zeitpunkt aufgenommenen Daten verglichen werden und aus dem Vergleich Schlüsse auf den Zustand des Rohrnetzes gezogen werden. Auch sind auf diese Weise durch Verschicken des Speichers Ferndiagnosen von einer zentralen Stelle aus durchführbar.

Die Erfindung wird im folgenden anhand einer ein Ausführungsbeispiel darstellenden Zeichnung näher erläutert.

Innerhalb eines Gehäuses 1 befindet sich ein Elektromotor an dem koaxial eine Kreiselpumpe 4 angeflanscht ist. Das Gehäuse 1 weist einen Einlaß 5 und einen Auslaß 6 auf.

Am seitlichen Rand des Gehäuses 1 ist eine Meßvorrichtung 7 vorgesehen, mittels der die elektrischen Betriebsgrößen des Motors 2, nämlich Stromaufnahme, Drehzahl und Leistungsaufnahme erfaßt werden. Innerhalb der Meßvorrichtung ist eine Recheneinheit angeordnet, die unter Berücksichtigung der für das jeweilige Zeitrohrnetz gültigen Pumpenkennlinien aus den elektrischen Betriebsgrößen die hydraulischen Betriebsgrößen der Pumpe 4, wie Differenzdruck, Volumenstrom und hydraulischen Widerstand, berechnet. Die Ausgangsleitungen der Meßvorrichtung 7 münden in einem Anschlußbaustein 8, der eine Anzahl von elektrischen Anschlußstiften aufweist.

Auf den Anschlußbaustein 8 ist ein weiterer Baustein 9 aufsteckbar, mittels dessen die von der Meßvorrichtung 7 ermittelten Meßwerte von außerhalb des Gehäuses erfaßbar sind. Dazu ist innerhalb des weiteren Bausteins 9 ein Meßwertspeicher 12 vorgesehen, in dem zu bestimmten vorgegebenen Zeiten die den elektrischen bzw. hydraulischen Betriebsgrößen entsprechenden Meßdaten abgelegt werden und für einen späteren Vergleich mit den dann aktuellen Meßwerten wieder abgerufen werden. Bei dem Speicher 12 handelt es sich um einen Speicher mit wahlfreiem Zugriff (RAM), welcher von einer Batterie gepuffert wird, so daß die Speicherung der Meßwerte von einer Netzspannungsversorgung unabhängig ist. Zusätzlich an den weiteren Baustein 9 angeschlossen werden kann eine Anzeigevorrichtung 10 für die elektrischen Betriebsgrößen des Motors 2, (Spannung U, Drehzahl N, Leistungsaufnahme P). Über eine weitere Anzeigevorrichtung 11 lassen sich die hydraulischen Betriebsgrößen Differenzdruck Δ P, Volumenstrom 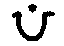 und hydraulischer Widerstand R h ausgeben, wobei der hydraulische Widerstand aus dem Quotienten von Δ P und 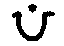 berechnet wird.

Der weitere Baustein 9 kann vorzugsweise in einer anderen Ausführungsform, die nicht dargestellt ist, auch als ein einfacher zweipoliger Klinkenstecker ausgeführt sein, wobei dann der Anschlußbaustein 8 eine serielle Schnittstelle bildet, über die die den gewünschten Betriebsgrößen entsprechenden Daten ausgelesen werden können.

Die Ausführung des weiteren Bausteins 9 bei dem erfindungsgemäßen Pumpenaggregat erlaubt seine Verwendung als Diagnosestecker. Hierdurch lassen sich nicht nur die elektrischen und hydraulischen Betriebsgrößen ständig anzeigen und überwachen sondern auch in Form einer Meßwertfolge im Speicher 12 ablegen. Die an einer zu untersuchenden Pumpe erfaßte Meßwertfolge kann daraufhin beispielsweise an einem anderen Ort, zu dem der Diagnosestecker einfach verschickt werden kann, analysiert werden. Durch Vergleich mit an einem Normpumpenaggregat ermittelten Sollwerten lassen sich auf diese Weise Fehlerdiagnosen an im Betrieb befindlichen Pumpenaggregaten durchführen. Eine allmähliche Veränderung des an das Aggregat angeschlossenen Leitungsrohmetzes z.B. durch Verschlammung läßt sich somit im Gegensatz zu beim Stand der Technik üblichen Meßverfahren mit geringem Aufwand feststellen.

In nicht dargestellten weiteren Ausführungsbeispielen ist die Schnittstelle berührungsfrei ausgeführt. Sie ist entweder als optische Schnittstelle ausgelegt, indem im Anschlußbaustein eine von den hydraulischen oder elektrischen Betriebsgrößen modulierte Leuchtdiode und im weiteren Baustein ein Fototransistor, der die Strahlung der Leuchtdiode erhält, angeordnet sind oder indem Anschlußbaustein und weiterer Baustein durch jeweilige Sender und Empfänger miteinander kommunizieren.

Aber auch bei der Neuerstellung von Heizungsanlagen läßt sich das erfindungsgemäße Pumpenaggregat einsetzen. Durch Vergleich von im Speicher 12 abgelegten Sollwerten für einen bestimmten Pumpentyp bzw. Typ eines Leitungsrohmetzes mit den während der Installation gemessenen Istwerten lassen sich die Betriebsbedingungen der zu installierenden Pumpe auf die vorgegebenen Sollwerte einstellen.

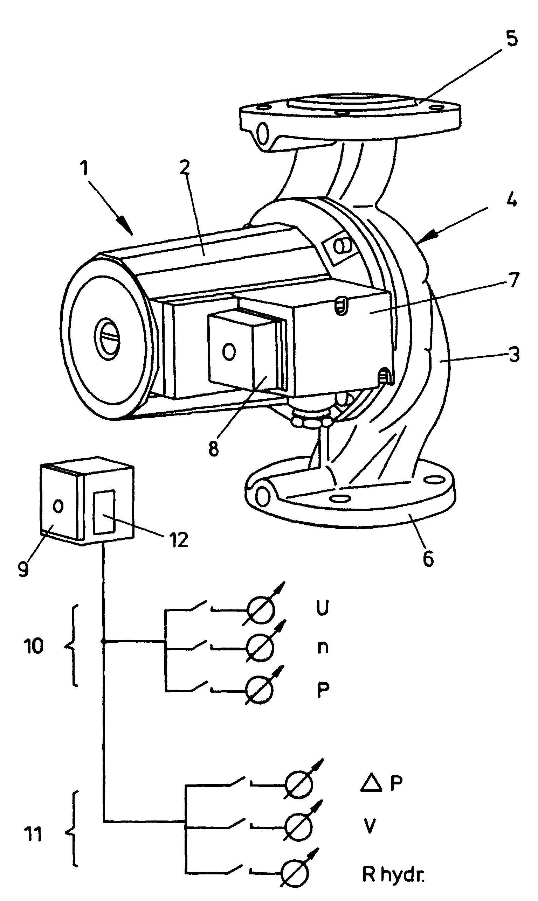

## Patentansprüche

1. Elektrisch angetriebenes Pumpenaggregat mit einem in einem Gehäuse (1) angeordneten Elektromotor (2) und einer Pumpe (4) sowie einem mit einer Meßvorrichtung (7) für die elektrischen bzw. hydraulischen Betriebsgrößen von Motor (2) bzw. Pumpe (4) verbundenen Anschlußbaustein (8), auf dem von außen lösbar ein weiterer Baustein (9) befestigbar ist, **dadurch gekennzeichnet**, daß der weitere Baustein (9) eine Registriervorrichtung (10, 11, 12) umfaßt, mittels der die Betriebsgrößen von Motor (2) und Pumpe (4) anzeigbar und/oder speicherbar sind.

2. Pumpenaggregat nach Anspruch 1,
**dadurch gekennzeichnet,** daß mit der Registriervorrichtung eine Anzeigevorrichtung (10) für die elektrischen Betriebsgrößen des Motors (2) verbunden ist.

3. Pumpenaggregat nach Anspruch 2,
**dadurch gekennzeichnet**, daß die Anzeigevorrichtung auf unterschiedliche elektrische Betriebsgrößen (Strom, Drehzahl, Leistung) des Motors (2) umschaltbar ist.

4. Pumpenaggregat nach einem der Ansprüche 1 bis 3,
**dadurch gekennzeichnet,** daß mit der Registriervorrichtung eine weitere Anzeigevorrichtung (11) für die hydraulischen Betriebsgrößen der Pumpe (4) verbunden ist.

5. Pumpenaggregat nach einem der Ansprüche 1 bis 4,
**dadurch gekennzeichnet**, daß die Registriervorrichtung einen elektronischen Speicher (12) enthält.

6. Pumpenaggregat nach Anspruch 5,
**dadurch gekennzeichnet**, daß der elektronische Speicher (12) ein batteriegepufferter Speicher mit wahlfreiem Begriff (RAM) ist.

7. Pumpenaggregat nach einem der Ansprüche 1 bis 6,
**dadurch gekennzeichnet**, daß der Anschlußbaustein (8) als serielle Schnittstelle für eine Datenleitung ausgebildet ist.

8. Pumpenaggregat nach Anspruch 7,
**dadurch gekennzeichnet**, daß der weitere Baustein (9) ein zweipoliger Klinkenstecker ist.

9. Pumpenaggregat nach einem der Ansprüche 1 bis 6,
**dadurch gekennzeichnet**, daß der Anschlußbaustein (8) eine Leuchtdiode enthält und daß der weitere Baustein (9) eine die Strahlung der Leuchtdiode aufnehmende Empfangseinrichtung, insbesondere einen Fototransistor, aufweist.

10. Pumpenaggregat nach einem der Ansprüche 1 bis 6,
**dadurch gekennzeichnet**, daß der Anschlußbaustein (8) einen Sender und der weitere Baustein (9) einen Empfänger für die drahtlose Übertragung der den Betriebsgrößen des Motors (2) entsprechenden Daten enthält.

11. Verwendung des Pumpenaggregates nach einem der Ansprüche 1 bis 8 für die Fehlersuche oder Fehlerdiagnose in bestehenden Leitungsrohrnetzen.

12. Verwendung des Pumpenaggregates nach einem der Ansprüche 1 bis 8 zur Analyse und Prüfung von neuerstellten Leitungsrohrnetzen.

## Claims

1. An electrically driven pump unit having: an electric motor (2) disposed in a casing (1), a pump (4) and a connection module (8) which is connected to a measuring device (7) for the electric and hydraulic operating values of the motor (2) and the pump (4) respectively and to which a further module (9) releasable from outside can be attached,
**characterised in that**, the further module (9) comprises a recording device (10, 11, 12) by means of which the operating values of the motor (2) and the pump (4) can be displayed and/or stored.

2. A pump unit according to claim 1,
**characterised in that** a display device (10) for the electric operating values of the motor (2) is connected to the recording device.

3. A pump unit according to claim 2,
**characterised in that** the display device can be switched over to different electric operating values (current, speed, power) of the motor (2).

4. A pump unit according to one of claims 1 to 3,
**characterised in that** a further display device (11) for the hydraulic operating values of the pump (4) is connected to the recording device.

5. A pump unit according to one of claims 1 to 4,
**characterised in that** the recording device comprises an electronic store (12).

6. A pump unit according to claim 5,
**characterised in that** the electric store (12) is a battery-buffered store with freely selectable access (RAM) .

7. A pump unit according to one of claims 1 to 6,
**characterised in that** the connection module (8) takes the form of a serial interface for a data wire.

8. A pump unit according to claim 7,
**characterised in that** the further module (9) is a bipolar plug switch.

9. A pump unit according to one of claims 1 to 6,
**characterised in that** the connection module (8) comprises a light emitting diode, and the further module (9) has a receiving device, more particularly a phototransistor, receiving the radiation of the light emitting diode.

10. A pump unit according to one of claims 1 to 6,
**characterised in that** the connection module (8) comprises a transmitter and the further module (9) comprises a receiver for the wireless transmission of the data corresponding to the operating values of the motor (2).

11. Use of the pump unit according to one of claims 1 to 8, for error detection or error diagnosis in existing pipe networks.

12. Use of the pump unit according to one of claims 1 to 8, for the analysis and testing of newly installed pipe networks.

## Revendications

1. Unité de pompe à entraînement électrique avec un moteur électrique (2) disposé dans un carter (1) et une pompe (4), ainsi qu'un bloc fonctionnel de raccordement (8) connecté à un dispositif de mesure (7) pour les grandeurs électriques ou respectivement hydrauliques d'exploitation du moteur (2) ou respectivement de la pompe (4), sur lequel un autre bloc fonctionnel (9) peut être fixé de manière amovible depuis l'extérieur,
caractérisée en ce que l'autre bloc fonctionnel (9) comprend un dispositif enregistreur (10, 11, 12) au moyen duquel les grandeurs d'exploitation du moteur (2) et de la pompe (4) peuvent être affichées et/ou mémorisées.

2. Unité de pompe selon la revendication 1,
caractérisée en ce qu'un dispositif d'affichage (10) pour les grandeurs électriques d'exploitation du moteur (2) est relié au dispositif enregistreur.

3. Unité de pompe selon la revendication 2,
caractérisée en ce que le dispositif d'affichage peut être commuté sur différentes grandeurs électriques d'exploitation (courant, vitesse de rotation, puissance) du moteur (2).

4. Unité de pompe selon l'une des revendications 1 à 3,
caractérisée en ce qu'un autre dispositif d'affichage (11) pour les grandeurs hydrauliques d'exploitation de la pompe (4) est relié au dispositif enregistreur.

5. Unité de pompe selon l'une des revendications 1 à 4,
caractérisée en ce que le dispositif enregistreur contient une mémoire électronique (12).

6. Unité de pompe selon la revendication 5,
caractérisée en ce que la mémoire électronique (12) est une mémoire à batterie tampon à concept aléatoire (RAM).

7. Unité de pompe selon l'une des revendications 1 à 6,
caractérisée en ce que le bloc fonctionnel de raccordement (8) est réalisé sous forme d'un interface pour un transmetteur de données.

8. Unité de pompe selon la revendication 7,
caractérisée en ce que l'autre bloc fonctionnel (9) est réalisé sous forme d'un connecteur bipolaire à jacks.

9. Unité de pompe selon l'une des revendications 1 à 6,
caractérisée en ce que le bloc fonctionnel de raccordement (8) contient une diode lumineuse et que l'autre bloc fonctionnel (9) présente un dispositif récepteur recevant le rayonnement de la diode lumineuse, en particulier un phototransistor.

10. Unité de pompe selon l'une des revendications 1 à 6,
caractérisée en ce que le bloc fonctionnel de raccordement (8) comprend un émetteur et l'autre bloc fonctionnel (9) un récepteur pour la transmission sans fil des données correspondant aux grandeurs d'exploitation du moteur (2).

11. Utilisation de l'unité de pompe selon l'une des revendications 1 à 8 pour la recherche de défauts ou le diagnostic de défauts dans des réseaux de tubes conducteurs existants.

12. Utilisation de l'unité de pompe selon l'une des revendications 1 à 8 pour l'analyse et le test de réseaux de tubes conducteurs neufs.
